# EUROPÄISCHE PATENTSCHRIFT

(11) **EP 3 537 167 B1**
(45) Veröffentlichungstag und Bekanntmachung des Hinweises auf die Patenterteilung: **24.04.2024**
(21) Anmeldenummer: 18160255.8
(22) Anmeldetag: 06.03.2018
(51) Int. Cl.: G01R 33/483, G01R 33/561, G01R 33/56, G01R 33/563

(54) **VERFAHREN UND VORRICHTUNG ZUR ERSTELLUNG EINER PULSSEQUENZ MIT VOLUMENSELEKTIVEN MAGNETISIERUNGSPRÄPARATIONSPULSEN IN EINER FESTGELEGTEN REIHENFOLGE ZUR ANSTEUERUNG EINES MAGNETRESONANZTOMOGRAPHIE-SYSTEMS**
METHOD AND DEVICE FOR GENERATING A PULSE SEQUENCE WITH VOLUME-SELECTIVE MAGNETIZATION PREPARATION PULSES IN A DEFINED ORDER FOR CONTROLLING A MAGNETIC RESONANCE TOMOGRAPHY SYSTEM
PROCÉDÉ ET DISPOSITIF DE GÉNÉRATION D'UNE SÉQUENCE D'IMPULSION AVEC DES IMPULSIONS DE PRÉPARATION À LA MAGNÉTISATION SÉLECTIVES EN VOLUME DANS UN ORDRE DÉFINI POUR COMMANDER UN SYSTÈME DE TOMOGRAPHIE PAR RÉSONANCE MAGNÉTIQUE

(43) Veröffentlichungstag der Anmeldung: 11.09.2019
(73) Patentinhaber: Siemens Healthineers AG, 91301 Forchheim (DE)
(72) Erfinder: Zeller, Mario, 91054 Erlangen (DE); Paul, Dominik, 91088 Bubenreuth (DE)
(74) Vertreter: Siemens Healthineers Patent Attorneys

(56) Entgegenhaltungen:
- US-A1- 2017 328 971
- US-A1- 2018 031 659
- MARKUS BARTH ET AL: "Simultaneous multislice (SMS) imaging techniques : SMS Imaging", MAGNETIC RESONANCE IN MEDICINE., Bd. 75, Nr. 1, 26. August 2015 (2015-08-26), Seiten 63-81, XP055408927, US ISSN: 0740-3194, DOI: 10.1002/mrm.25897

## Beschreibung

Die Erfindung betrifft ein Verfahren und eine Vorrichtung zur Erstellung einer Pulssequenz zur Ansteuerung eines Magnetresonanztomographie-Systems, sowie eine solche Pulssequenz und ein entsprechendes Steuerverfahren bzw. eine entsprechende Steuervorrichtung und ein entsprechendes Magnetresonanztomographie-System.

Bildgebende Systeme, die auf einem Verfahren der Magnetresonanzmessung, insbesondere von Kernspins basieren, sogenannte Magnetresonanztomographen, haben sich durch vielfältige Anwendungen erfolgreich etabliert und bewährt. Bei dieser Art der Bildakquisition wird meist ein statisches Grundmagnetfeld B₀, das zur Anfangsausrichtung und Homogenisierung von zu untersuchenden magnetischen Dipolen dient, zur Ortsauflösung des bildgebenden Signals mit einem schnell geschalteten Magnetfeld, dem sogenannten Gradientenfeld, überlagert. Zur Bestimmung von Materialeigenschaften eines abzubildenden Untersuchungsobjekts wird die Dephasierung bzw. Relaxationszeit nach einer Auslenkung der Magnetisierung aus der Anfangsausrichtung ermittelt, sodass verschiedene materialtypische Relaxationsmechanismen bzw. Relaxationszeiten identifiziert werden können. Die Auslenkung erfolgt meist durch eine Anzahl von HF-Pulsen und die Ortsauflösung beruht dabei auf einer zeitlich festgelegten Manipulation der ausgelenkten Magnetisierung mit Hilfe des Gradientenfeldes in einer sogenannten Messsequenz bzw. Pulssequenz, welche eine genaue zeitliche Abfolge von HF-Pulsen, der Änderung des Gradientenfeldes (durch Aussenden einer Schaltsequenz von Gradientenpulsen) sowie der Erfassung von Messwerten festlegt. Neben der Relaxation gibt es noch eine Reihe weiterer Mechanismen zur Kontrastbildung, wie zum Beispiel die Flussmessung und die Diffusionsbildgebung.

Typischerweise erfolgt eine Zuordnung zwischen gemessener Magnetisierung, aus der die erwähnten Materialeigenschaften abgeleitet werden können, und einer Ortskoordinate der gemessenen Magnetisierung im Ortsraum, in dem das Untersuchungsobjekt angeordnet ist, mit Hilfe eines Zwischenschritts. In diesem Zwischenschritt werden erfasste Magnetresonanz-Rohdaten an Auslesepunkten im sogenannten "k-Raum" angeordnet, wobei die Koordinaten des k-Raums als Funktion des Gradientenfeldes kodiert sind. Der Betrag der Magnetisierung (insbesondere der Quermagnetisierung, in einer Ebene quer zum vorbeschriebenen Grundmagnetfeld bestimmt) an einem bestimmten Ort des Untersuchungsobjekts kann aus den k-Raum-Daten mit Hilfe einer Fourier-Transformation ermittelt werden. Anders ausgedrückt, werden die k-Raum-Daten (Magnitude und Phase) benötigt, um eine Signalstärke des Signals und gegebenenfalls dessen Phase im Ortsraum zu berechnen.

Die Magnetresonanztomographie ist eine relativ langsam arbeitende Art eines bildgebenden Verfahrens, da die Daten entlang von Trajektorien, wie zum Beispiel Zeilen oder Spiralen, im Fourierraum bzw. im k-Raum sequentiell aufgenommen werden. Das Verfahren der Aufnahme von Bildern in zweidimensionalen Schichten ist im Vergleich zur Aufnahme in drei Dimensionen deutlich weniger fehleranfällig, weil die Zahl der Kodierungsschritte kleiner ist als bei einem dreidimensionalen Verfahren. Daher werden bei vielen Anwendungen Bildvolumen mit Stapeln von zweidimensionalen Schichten statt einer einzigen dreidimensionalen Aufnahme verwendet. Allerdings sind die Bildaufnahmezeiten aufgrund der langen Relaxationszeiten der Spins sehr lang, was beispielsweise für zu untersuchende Patienten eine Verringerung des Komforts bedeutet. Auch können die Patienten während der Aufnahme nicht kurz den Magnetresonanztomographen verlassen oder auch nur ihre Position ändern, da dies aufgrund der Positionsveränderung den Bildaufnahmevorgang zunichtemachen würde und der gesamte Prozess von vorne beginnen müsste. Folglich besteht ein wichtiges Ziel darin, die Aufnahme von zweidimensionalen Schichtstapeln zu beschleunigen.

Bei einer anderen Abtastungsart werden selektiv angeregte Subvolumen oder Teilvolumen (sogenannte "Schichten", "Slices" oder "Slabs") mit Hilfe eines dreidimensionalen Abtastverfahrens ortskodiert. Auch bei dieser Vorgehensweise besteht ein Bedarf, die Aufnahmegeschwindigkeit zu beschleunigen.

Zur Beschleunigung der Bildaufnahme finden beispielsweise parallele Bildaufnahmetechniken Anwendung. Mit diesen unter den Namen "Simultaneous Multi-Slice" (SMS-Bildaufnahmen), "Slice Acceleration" oder auch "Multiband" bekannten Technologien werden mehrere Schichten gleichzeitig angeregt und ausgelesen (siehe z. B. Breuer et al. MRM 53: 684 (2005), Souza et al. JCAT 12: 1026 (1988), Larkman et al. JMRI 13: 313 (2001), (MRM = Magnetic Resonance in Medicine, JCAT = Journal of Computer Assisted Tomography, JMRI = Journal of Magnetic Resonance Imaging)). Beispielsweise werden bei einem Beschleunigungsfaktor von 3 jeweils 3 Schichten gleichzeitig angeregt und ausgelesen. Hierdurch reduziert sich die benötigte Repetitionszeit TR (Repetitionszeit TR = Zeit, bis aufeinanderfolgende Pulsfolgen auf die gleiche Schicht angewandt werden) auf 1/3 der benötigten Zeit. Vorteilhaft wird mit diesen Methoden die Messzeit reduziert beziehungsweise die zeitliche Abtastrate erhöht.

Verschiedene SMS-Techniken sind in dem Übersichtsartikel von Barth et al. "Simultaneous multislice (SMS) inaging techniques:", Magn. Reson. Med. 75: S. 63-81 (2016) beschrieben. Ein zeitlich verschachteltes SMS-Verfahren ist in der US 2017/328971 A1 offenbart. Die US 2018/031659 A1 offenbart ein Multi-Kontrast SMS-Verfahren.

Auch bei der Abtastung von selektiv angeregten Subvolumen besteht die Möglichkeit, mit Hilfe einer "Multi-Slab"-Bildgebung simultan mehrere Subvolumen abzutasten, um den Aufnahmevorgang zu beschleunigen. Eine solche Vorgehensweise kann als Zwischenstufe zwischen einer 2D-Mehrschicht-Bildgebung und einer vollständigen 3D-Bildgebung angesehen werden.

Ein großer Nachteil bei der simultanen Aufnahme von mehreren Teilvolumina mittels bekannter Verfahren ist, dass es bei der Aufnahme zu Bildartefakten kommen kann, z.B. aufgrund von Übersprechern ("Cross Talk") zwischen zwei benachbarten Teilvolumina oder aufgrund von Magnetisierungstransfereffekten, welche die Bildqualität negativ beeinflussen.

Es ist eine Aufgabe der vorliegenden Erfindung, die oben beschriebenen Nachteile zu vermeiden und eine verbesserte Aufnahme von Multi-Kontrast SMS-Magnetresonanzbildern zu erreichen. Dazu gehört die Aufgabe, ein Verfahren und eine Vorrichtung zur Erstellung einer Pulssequenz, sowie eine solche Pulssequenz zur Verfügung zu stellen, so dass eine Pulssequenz zur Ansteuerung eines Magnetresonanztomographie-Systems für ein entsprechendes Steuerverfahren bzw. eine entsprechende Steuervorrichtung und ein entsprechendes Magnetresonanztomographie-System zur Verfügung gestellt werden kann.

Diese Aufgabe wird durch ein Verfahren gemäß Patentanspruch 1, eine Pulssequenz gemäß Patentanspruch 8, eine Vorrichtung gemäß Patentanspruch 9 sowie durch ein Steuerverfahren gemäß Patentanspruch 10 eine Steuereinrichtung gemäß Patentanspruch 12 und ein Magnetresonanztomographie-System gemäß Patentanspruch 13 gelöst.

Das erfindungsgemäße Verfahren dient, genau wie die erfindungsgemäße Vorrichtung, zur Erstellung einer Pulssequenz zur Ansteuerung eines Magnetresonanztomographie-Systems zur Erzeugung von Magnetresonanzbilddaten eines Untersuchungsobjekts, bei dem zur Erfassung von Magnetresonanzrohdaten unterschiedliche Transversalmagnetisierungen in einer Mehrzahl von abzubildenden, insbesondere parallel zueinander angeordneten, Teilvolumina angeregt werden und zur Bildgebung genutzt werden. Mit anderen Worten betrifft es Multi-Kontrast-Aufnahmen, bei denen mehrere Schichten gleichzeitig angeregt werden, wobei mindestens eine der gleichzeitig angeregten Schichten eine andere Präparation erfährt als eine der anderen gleichzeitig angeregten Schichten. Diese Präparation dient zur Erreichung der Unterschiede in den Transversalmagnetisierungen zwischen den verschiedenen Teilvolumina. Dies kann z.B. durch Präparationsmodule geschehen, die nur auf ein Subset der Schichten wirken und/oder durch zeitlichen Versatz der Anregungspulse und/oder durch unterschiedliche Flipwinkel. Bei den Sequenztypen gibt es dabei zunächst keine Beschränkung. Vorteilhaft ist eine zweidimensionale Aufnahme (z.B. TSE, GRE, EPI, segmentierte EPI). Besonders vorteilhaft ist die Anwendung des Verfahrens wenn Übersprecher- ("Cross Talk-") oder Magnetisierungstransfereffekte auftreten können. Das ist besonders bei FLAIR der Fall, da dort die FLAIR-Inversionsschicht so breit gewählt ist, dass sie die Nachbarschichten teilweise überlappt.

Im Rahmen des erfindungsgemäßen Verfahrens umfasst die Pulssequenz eine Folge von Puls-Iterationen, die dazu ausgelegt sind, Teilvolumina zu präparieren, anzuregen und auszulesen. Die Puls-Iterationen werden dabei in der Pulssequenz in einer Weise angeordnet, dass bei einer Applikation der Pulssequenz zwischen einer Präparation zweier räumlich direkt benachbarter Teilvolumina eine Auslese erfolgt. Dies gilt bevorzugt für den wesentlichen Teil der Teilvolumina, besonders bevorzugt für alle Teilvolumina, auf welche die Pulssequenz wirkt.

Bei dem Aufnahmeverfahren, auf die sich die Erfindung bezieht werden Teilvolumina gleichzeitig angeregt und ausgelesen. Die können durchaus die beiden benachbarten Teilvolumina sein, aber auch nicht-benachbarte Teilvolumina.

Die Folge von Puls-Iterationen ist bevorzugt dazu ausgelegt, neben einer Präparation von einzelnen Teilvolumina, dieselben oder weitere Teilvolumina gleichzeitig anzuregen und auszulesen. Wohlgemerkt müssen dies nicht die benachbarten Teilvolumina sein (s.o.), sondern es können z.B. zwei nicht-benachbarte Teilvolumina gleichzeitig angeregt und ausgelesen werden. Wichtig für das erfindungsgemäße Verfahren ist hier nicht die Anregung, sondern dass zwei (bzw. ein Großteil oder alle) benachbarte Teilvolumina in unterschiedlichen Puls-Iterationen präpariert werden.

Bevorzugt sind die gleichzeitig angeregten und ausgelesenen Schichten maximal beabstandet. Bei vier Schichten würden bei zwei gleichzeitig ausgelesenen Schichten z.B. bevorzugt Schichten 1 und 3 und Schichten 2 und 4 gleichzeitig angeregt und ausgelesen. Es ist je nach Anwendungsfall auch bevorzugt, dass nicht nur zwei, sondern mehrere Schichten gleichzeitig angeregt und ausgelesen werden. Das erfindungsgemäße Verfahren ist dann selbstverständlich ebenfalls anwendbar. Bei einer Anzahl von N Schichten, von denen A gleichzeitig ausgelesen werden, würden entsprechend bevorzugt die Schichten i (mit i<N/A), i+(N/A), i+((N+1)/A), ... gleichzeitig angeregt und ausgelesen.

Eine erfindungsgemäße Pulssequenz wurde bevorzugt mit dem erfindungsgemäßen Verfahren erstellt und dient zur Ansteuerung eines Magnetresonanztomographie-Systems zur Erzeugung von Magnetresonanzbilddaten eines Untersuchungsobjekts, bei dem Magnetresonanzrohdaten erfasst werden, wobei unterschiedliche Transversalmagnetisierungen in einer Mehrzahl von abzubildenden Teilvolumina angeregt werden und zur Bildgebung genutzt werden, wobei diese unterschiedlichen Transversalmagnetisierungen mindestens in einem Zeitabschnitt der Messung simultan vorliegen.

Die erfindungsgemäße Pulssequenz umfasst eine Folge von Puls-Iterationen, die dazu ausgelegt sind, Teilvolumina zu präparieren, anzuregen und auszulesen, wobei die Puls-Iterationen in der Pulssequenz in einer Weise angeordnet sind, dass bei einer Applikation der Pulssequenz zwischen einer Präparation zweier räumlich direkt benachbarter Teilvolumina eine Auslese erfolgt. Dies gilt wie oben bereits gesagt bevorzugt für den wesentlichen Teil der Teilvolumina, besonders bevorzugt für alle Teilvolumina, auf welche die Pulssequenz wirkt.

Die erste Puls-Iteration umfasst ein erstes Präparationspulsmodul zur Präparation eines ersten Teilvolumens, und ein erstes Auslesemodul nach dem ersten Präparationspulsmodul, und die zweite Puls-Iteration ein zweites Präparationspulsmodul zur Präparation eines zweiten Teilvolumens, und ein zweites Auslesemodul nach dem zweiten Präparationspulsmodul. Die Präparationspulsmodule sind dabei so in der Pulssequenz angeordnet, dass bei einer Applikation der Pulssequenz eine Präparation direkt benachbarter Teilvolumina in unterschiedlichen Puls-Iterationen erfolgt.

Eine erfindungsgemäße Vorrichtung zur Erstellung einer erfindungsgemäßen Pulssequenz, welche auch als "Pulssequenz-Ermittlungssystem" bezeichnet werden könnte, umfasst eine Erstellungseinheit welche dazu ausgelegt ist, eine Pulssequenz mit mindestens zwei aufeinander folgenden Puls-Iterationen zum Präparieren, Anregen und Auslesen von Teilvolumina zu generieren.

Die Erstellungseinheit ist dabei so gestaltet, dass Puls-Iterationen in der Pulssequenz in einer Weise angeordnet werden, dass bei einer Applikation der Pulssequenz zwischen einer Präparation zweier räumlich direkt benachbarter Teilvolumina eine Auslese erfolgt. Es gelten auch die vorangehenden Ausführungen entsprechend.

Die Erstellungseinheit ist bevorzugt zusätzlich dazu ausgelegt, in der ersten Puls-Iteration ein erstes Präparationspulsmodul zur Präparation eines ersten Teilvolumens gefolgt von einem ersten Auslesemodul anzuordnen und in der zweiten Puls-Iteration ein zweites Präparationspulsmodul zur Präparation eines zweiten Teilvolumens gefolgt von einem zweiten Auslesemodul anzuordnen, so dass die Präparationspulsmodule so angeordnet sind, dass bei einer Applikation der Pulssequenz eine Präparation direkt benachbarter Teilvolumina im Wesentlichen, insbesondere stets in unterschiedlichen Puls-Iterationen erfolgt.

Ein erfindungsgemäßes Steuerverfahren zur Ansteuerung eines Magnetresonanztomographie-Systems zur Erzeugung von Magnetresonanzbilddaten eines Untersuchungsobjekts, bei dem Magnetresonanzrohdaten erfasst werden, wobei unterschiedliche Transversalmagnetisierungen in einer Mehrzahl von abzubildenden Teilvolumina angeregt werden und zur Bildgebung genutzt werden, umfasst die folgenden Schritte:
- Erstellung einer erfindungsgemäßen Pulssequenz.
- Applikation der Pulssequenz im Rahmen einer Magnetresonanztomographie-Aufnahme des Magnetresonanztomographie-Systems, wobei eine Präparation der Teilvolumina basierend auf der Pulssequenz erfolgt. Dabei wird bevorzugt das erste Teilvolumen mit dem ersten Präparationspulsmodul präpariert und das zweite Teilvolumen mit dem zweiten Präparationspuls.

Eine erfindungsgemäße Steuereinrichtung zur Steuerung eines Magnetresonanztomographie-Systems ist zur Durchführung eines erfindungsgemäßen Steuerverfahrens ausgelegt und umfasst eine erfindungsgemäße Vorrichtung, also ein Pulssequenz-Ermittlungssystem.

Ein erfindungsgemäßes Magnetresonanztomographie-System umfasst eine erfindungsgemäße Steuereinrichtung.

Ein Großteil der zuvor genannten Komponenten der Vorrichtung bzw. der Steuereinrichtung, können ganz oder teilweise in Form von Softwaremodulen in einem Prozessor einer entsprechenden Vorrichtung bzw. Steuereinrichtung realisiert werden. Eine weitgehend softwaremäßige Realisierung hat den Vorteil, dass auch schon bisher verwendete Vorrichtungen bzw. Steuereinrichtungen auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem ComputerProgramm gelöst, welches direkt in ein Rechensystem bzw. eine Speichereinrichtung einer Steuereinrichtung eines Magnetresonanztomographiesystems ladbar ist, mit Programmabschnitten, um alle Schritte des erfindungsgemäßen Verfahrens auszuführen, wenn das Programm in dem Rechensystem bzw. der Steuereinrichtung ausgeführt wird. Ein solches Computerprogrammprodukt kann neben dem Computerprogramm gegebenenfalls zusätzliche Bestandteile wie z. B. eine Dokumentation und/oder zusätzliche Komponenten auch Hardware-Komponenten, wie z.B. Hardware-Schlüssel (Dongles etc.) zur Nutzung der Software, umfassen

Zum Transport zum Rechensystem bzw. zur Steuereinrichtung und/oder zur Speicherung an oder in dem Rechensystem bzw. der Steuereinrichtung kann ein computerlesbares Medium, beispielsweise ein Memorystick, eine Festplatte oder ein sonstiger transportabler oder fest eingebauter Datenträger dienen, auf welchem die von einem Rechensystem bzw. einer Rechnereinheit der Steuereinrichtung einlesbaren und ausführbaren Programmabschnitte des Computerprogramms gespeichert sind. Die Rechnereinheit kann z.B. hierzu einen oder mehrere zusammenarbeitende Mikroprozessoren oder dergleichen aufweisen. Weitere, besonders vorteilhafte Ausgestaltungen und Weiterbildungen der Erfindung ergeben sich aus den abhängigen Ansprüchen sowie der nachfolgenden Beschreibung, wobei die Ansprüche einer Anspruchskategorie auch analog zu den Ansprüchen und Beschreibungsteilen zu einer anderen Anspruchskategorie weitergebildet sein können und insbesondere auch einzelne Merkmale verschiedener Ausführungsbeispiele bzw. Varianten zu neuen Ausführungsbeispielen bzw. Varianten kombiniert werden können, falls dies vom Schutzumfang der Erfindung, welcher durch die Ansprüche definiert ist, umfasst ist.

Die Pulssequenz umfasst mindestens zwei aufeinander folgende Puls-Iterationen, wie oben bereits angedeutet wurde. Dabei umfasst die erste Puls-Iteration ein erstes Präparationspulsmodul zur Präparation eines ersten Teilvolumens und ein erstes Auslesemodul nach dem ersten Präparationspulsmodul und die zweite Puls-Iteration ein zweites Präparationspulsmodul zur Präparation eines zweiten Teilvolumens, und ein zweites Auslesemodul nach dem zweiten Präparationspulsmodul. Bevorzugt umfasst ein Präparationsmodul zur Präparation eines Teilvolumens mindestens einen Präparationspuls, dessen Form von dem aufzunehmenden Kontrast abhängt (z.B. einen 180°-Puls für eine FLAIR-Sequenz).

Die erste Puls-Iteration umfasst zwischen dem ersten Präparationspulsmodul und dem ersten Auslesemodul mindestens ein drittes Präparationspulsmodul zum Präparieren eines dritten Teilvolumens, und bevorzugt nach dem ersten Auslesemodul ein drittes Auslesemodul. Dabei sind das erste und dritte Teilvolumen nicht direkt benachbart, bzw. liegt zwischen dem erstem und dem drittem Teilvolumen ein weiteres Teilvolumen, das nicht in der ersten Puls-Iteration präpariert wird.

Ergänzend kann die zweite Puls-Iteration bevorzugt zwischen dem zweiten Präparationspulsmodul und dem zweiten Auslesemodul mindestens ein viertes Präparationspulsmodul zum Präparieren eines vierten Teilvolumens und bevorzugt nach dem zweiten Auslesemodul ein viertes Auslesemodul umfassen. Dabei sind das zweite und vierte Teilvolumen nicht direkt benachbart, bzw. liegt zwischen dem zweiten und dem vierten Teilvolumen ein weiteres Teilvolumen, das nicht in der zweiten Puls-Iteration präpariert wird.

Bevorzugt wird die Pulssequenz basierend auf einer automatisch ermittelten Ablauf-Tabelle erstellt. Dabei wird zunächst eine Teilvolumenmenge von räumlich direkt benachbarten, parallel angeordneten Teilvolumina, eine Anregungsmenge der gleichzeitig angeregten Teilvolumina der Teilvolumenmenge und einer Messungs-Menge umfassend die durchzuführenden Messungen an den Teilvolumina eingegeben, welche die Basis für die Ermittlung der Ablauf-Tabelle darstellen. Die zeitliche Positionierung der Präparationspulsmodule und der Auslesemodule wird so vorgenommen, dass bei einer Applikation der Pulssequenz eine Präparation direkt benachbarter Teilvolumina in unterschiedlichen Puls-Iterationen erfolgt. Es erfolgt also zwischen der Präparation zweier räumlich direkt benachbarter Teilvolumina eine Auslese.

Bevorzugt wird die Pulssequenz so gebildet, dass die zeitlichen Abstände von Gruppen von Präparationspulsmodulen, insbesondere aller Präparationspulsmodule, zur Präparation direkt benachbarten Teilvolumina im Wesentlichen gleich ist. Dabei erfolgt bevorzugt in einer ersten Puls-Iteration, insbesondere vor dem ersten Auslesemodul, eine zeitlich aufeinanderfolgende Präparation jedes Teilvolumens mit (entweder) ungeradzahliger oder geradzahliger Position.

Bevorzugt umfasst die Pulssequenz eine Sequenz der Gruppe EPI (Echo Planar Imaging), insbesondere segmentiertes EPI, GRE (Gradienten-Echo), RESOLVE (In Ausleserichtung segmentierte Echo-Planar-Bildgebungssequenz), SE (Spin Echo), STEAM (Stimulated Echo Acquisition Mode), STIR (Short-Tau Inversion Recovery), TSE (Turbo-Spin-Echo) und FLAIR (Fluid Attenuated Inversion Recovery). Besonders bevorzugt ist dabei eine FLAIR-Sequenz, also eine MRT-Sequenz, mit der man zwischen freier und gewebsgebundener Flüssigkeit unterscheiden kann.

Bevorzugt ist die Pulssequenz zur Aufnahme eines der folgenden Kontraste ausgelegt:
- Spin-Gitter-Relaxation T1 (Längsrelaxationszeit)
- Spin-Spin-Relaxation T2 (Querrelaxationzeit)
- Protonendichte PD

Dabei sind die folgenden Kontrastkombinationen bevorzugt:
- Kombination mit Inversionspräparationen, insbesondere
   - T1 oder T2 oder PD kombiniert mit T1 FLAIR oder T2 FLAIR oder PD FLAIR
   - T1 oder T2 oder PD kombiniert mit T1 STIR oder T2 STIR oder PD STIR
- Kombination mit räumlich selektiver Fettsättigung, insbesondere
   - T1 oder T2 oder PD kombiniert mit T1-fs oder T2-fs oder PD-fs (fs: fat saturation)
- Kombination mit Diffusion, insbesondere
   - EPI T2* kombiniert mit EPI Diffusionsgewichteter Bildgebung, RESOLVE T2* kombiniert mit RESOLVE Diffusionsgewichteter Bildgebung,
- T1-Präparation (STEAM), insbesondere
   - T2 kombiniert mit T1-STEAM.

Bevorzugt umfasst die Pulssequenz weitere Pulse oder Gradienten, insbesondere Spoiler-Gradienten, Diffusions-Gradienten oder Flusskompensations-Gradienten.

Ein bevorzugtes Steuerverfahren umfasst die folgenden Schritte:
- Wählen einer Teilvolumenmenge von räumlich direkt benachbarten, parallel angeordneten Teilvolumina.
- Wählen einer Anregungsmenge der gleichzeitig angeregten Teilvolumina der Teilvolumenmenge.
- Wählen einer Messungs-Menge umfassend die durchzuführenden Messungen an den Teilvolumina. Diese durchzuführenden Messungen können z.B. als Repetitionen (also Wiederholungsmuster von Teilvolumina) vorliegen oder als Konkatenationen (Verknüpfungsmuster von Teilvolumina).
- Automatische Erstellung einer Pulssequenz gemäß des erfindungsgemäßen Verfahrens, wobei die Verteilung der Präparationspulsmodule auf die Messungs-Menge so gewählt wird, dass innerhalb einer Messung möglichst wenig benachbarte Teilvolumina, insbesondere keine benachbarten Teilvolumina, von einem der Präparationspulsmodule (also gleichzeitig) präpariert werden. Die automatische Erstellung einer Pulssequenz erfolgt insbesondere mittels Anlegen einer zeitlichen Ablauf-Tabelle (s.o.).
- Präparation der Teilvolumina mittels der Pulssequenz für eine Messung, wobei bevorzugt jeweils Teilvolumina gemäß der Anregungsmenge in einer Messung gleichzeitig angeregt und ausgelesen werden und von diesen gleichzeitig angeregt und ausgelesenen Teilvolumina (insbesondere unter Berücksichtigung der Ablauf-Tabelle) jeweils mindestens ein Teilvolumen vorab mit einem Präparationspulsmodul präpariert wurde.
- Wiederholung der Präparation der Teilvolumina bis alle Messungen, also die im Beispiel erwähnten Repetitionen bzw. Konkatenationen, aufgenommen wurden.

Die Erfindung wird im Folgenden unter Hinweis auf die beigefügten Figuren anhand von Ausführungsbeispielen noch einmal näher erläutert. Dabei sind in den verschiedenen Figuren gleiche Komponenten mit identischen Bezugsziffern versehen. Die Figuren sind in der Regel nicht maßstäblich. Es zeigen:
Figur 1 eine schematische Darstellung eines Magnetresonanztomographiesystems gemäß einem Ausführungsbeispiel der Erfindung,
Figur 2 eine Puls-Iteration als Teil einer beispielhaften Pulssequenz, welche jedoch nicht Teil der beanspruchten Erfindung ist.
Figur 3 eine weitere Puls-Iteration als Teil einer beispielhaften Pulssequenz, welche jedoch nicht Teil der beanspruchten Erfindung ist.
Figur 4 eine Ablauf-Tabelle als Beispiel einer Pulssequenz gemäß dem Stand Technik,
Figur 5 eine Ablauf-Tabelle als Beispiel einer bevorzugten Pulssequenz gemäß der Erfindung,
Figur 6 eine Ablauf-Tabelle als weiteres Beispiel einer bevorzugten Pulssequenz gemäß der Erfindung.

Im Folgenden werden sehr vereinfachte Diagramme von Pulssequenzen gezeigt. Zum besseren Verständnis der Erfindung sind die verschiedenen Pulse in Abhängigkeit von der Zeit t teilweise auf einem gemeinsamen Zeitstrang oder in einer Tabelle dargestellt. Normalerweise werden in einem Pulsdiagramm einer Gradientenechosequenz die auszusendenden Hochfrequenzpulse (die HF-Pulse), sowie die Gradientenpulse auf verschiedenen, übereinander liegenden Zeitachsen dargestellt. Üblicherweise werden die HF-Pulse auf einer Hochfrequenzpuls-Zeitachse dargestellt und die Gradientenpulse auf drei Gradientenpuls-Zeitachsen dargestellt, welche drei Raumrichtungen entsprechen. Also können z.B. Auslese-Gradientenpulse bezüglich ihrer Amplituden auf die drei Gradientenachsen aufgeteilt sein, und somit je nach Bedarf im Raum orientiert sein.

In den folgenden Figuren sind vorwiegend für die Erfindung wesentliche oder zu ihrem Verständnis hilfreiche Elemente eingezeichnet.

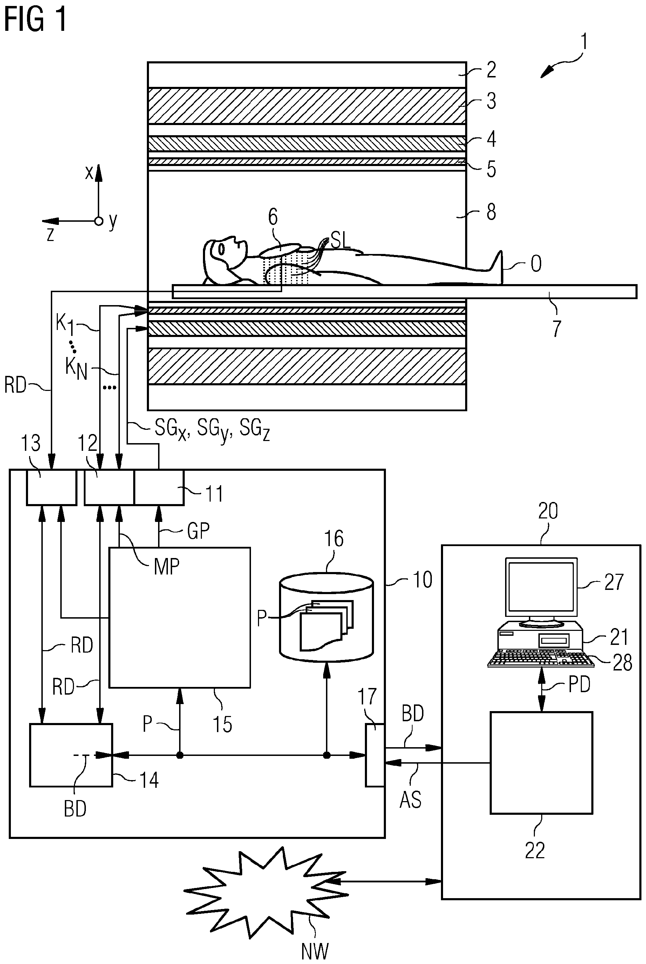

Fig. 1 zeigt grob schematisch ein erfindungsgemäßes Magnetresonanztomographie-System 1. Es umfasst den eigentlichen Magnetresonanzscanner 2 mit einem darin befindlichen Messraum 8 bzw. Patiententunnel. Eine Liege 7 ist in diesen Patiententunnel 8 hineinfahrbar, so dass ein darauf liegendes Untersuchungsobjekt O (beispielsweise Patient/Proband oder ein zu untersuchendes Material) während einer Untersuchung an einer bestimmten Position innerhalb des Magnetresonanzscanners 2 relativ zu dem darin angeordneten Magnetsystem und Hochfrequenzsystem gelagert werden kann bzw. auch während einer Messung zwischen verschiedenen Positionen verfahrbar ist.

Wesentliche Komponenten des Magnetresonanzscanners 2 sind ein Grundfeldmagnet 3, ein Gradientensystem 4 mit Gradientenspulen, um beliebige Magnetfeldgradienten in x-, y- und z-Richtung anzulegen, sowie eine Ganzkörper-Hochfrequenzspule 5. Alternativ oder zusätzlich können auch lokale Sendespulen zur Anregung von Magnetresonanzsignalen eingesetzt werden, wie es zum Beispiel bei der Kniebildgebung häufig der Fall ist.

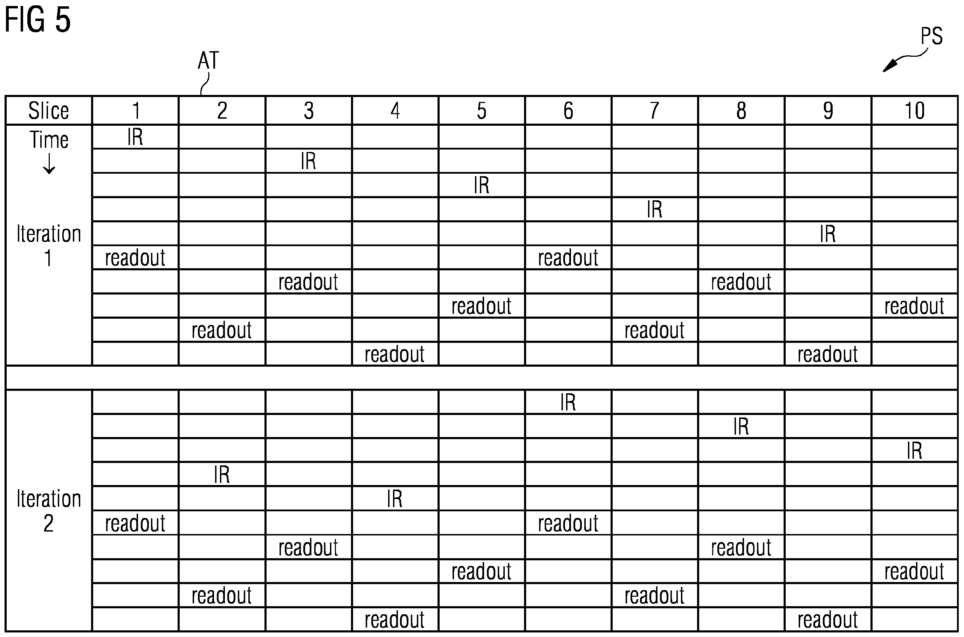

Der Empfang von im Untersuchungsobjekt O induzierten Magnetresonanzsignalen kann über die Ganzkörperspule 5 erfolgen, mit der in der Regel auch die Hochfrequenzsignale zur Induzierung der Magnetresonanzsignale ausgesendet werden. Üblicherweise werden diese Signale aber mit beispielsweise auf oder unter das Untersuchungsobjekt O gelegten Lokalspulen 6 empfangen. Alle diese Komponenten sind dem Fachmann grundsätzlich bekannt und daher in der Fig. 5 nur grob schematisch dargestellt.

Die Ganzkörper-Hochfrequenzspule 5 kann z. B. in Form einer so genannten Birdcage-Antenne eine Anzahl N von einzelnen Antennenstäben aufweisen, die als einzelne Sendekanäle K₁, ..., K_{N} separat von einer Steuereinrichtung 10 ansteuerbar sind, d. h. es handelt sich bei dem Magnetresonanztomographie-System 1 um ein pTX-fähiges System. Es wird aber ausdrücklich darauf hingewiesen, dass das erfindungsgemäße Verfahren auch an klassischen Magnetresonanztomographie-Systemen mit nur einem Sendekanal anwendbar ist.

Bei der Steuereinrichtung 10 kann es sich um einen Steuerrechner handeln, der auch aus einer Vielzahl von - ggf. auch räumlich getrennten und über geeignete Bussysteme bzw. Kabel oder dergleichen untereinander verbundenen - Einzelrechnern bestehen kann. Über eine Terminalschnittstelle 17 ist diese Steuereinrichtung 10 mit einem Terminal 20 verbunden, über das ein Bediener das gesamte Magnetresonanztomographie-System 1 ansteuern kann. Im vorliegenden Fall weist dieses Terminal 20 einen Rechner 21 mit Tastatur 28, einem oder mehreren Bildschirmen 27 sowie weiteren Eingabegeräten wie beispielsweise Maus oder dergleichen auf, so dass dem Bediener eine grafische Benutzeroberfläche zur Verfügung steht.

Die Steuereinrichtung 10 weist u. a. eine Gradienten-Steuereinheit 11 auf, die wiederum aus mehreren Teilkomponenten bestehen kann. Über diese Gradienten-Steuereinheit 11 werden die einzelnen Gradientenspulen mit Steuersignalen SGx, SGy, SGz beschaltet. Hierbei handelt es sich um Gradientenpulse, die während einer Messung an genau vorgesehenen zeitlichen Positionen und mit einem genau vorgegebenen zeitlichen Verlauf gesetzt werden, um das Untersuchungsobjekt O und den zugeordneten k-Raum vorzugsweise in einzelnen Schichten SL gemäß einer Pulssequenz PS abzutasten.

Die Steuereinrichtung 10 weist außerdem eine Hochfrequenz-Sende-/Empfangseinheit 12 auf. Diese HF-Sende-/Empfangseinheit 12 besteht ebenfalls aus mehreren Teilkomponenten, um jeweils separat und parallel auf die einzelnen Sendekanäle K₁, ... K_{N}, d. h. in diesem Fall auf die einzeln ansteuerbaren Antennenstäbe der Bodycoil 5, Hochfrequenzpulse aufzugeben. Über die Sende-/Empfangseinheit 12 können auch Magnetresonanzsignale empfangen werden. In diesem Ausführungsbeispiel geschieht dies aber mit Hilfe der Lokalspulen 6. Die mit diesen Lokalspulen 6 empfangenen Rohdaten RD werden von einer HF-Empfangseinheit 13 ausgelesen und verarbeitet. Die hiervon oder von der Ganzkörperspule 5 mittels der HF-Sende-/Empfangseinheit 12 empfangenen Magnetresonanzsignale werden als Rohdaten RD an eine Rekonstruktionseinheit 14 übergeben, die daraus die Bilddaten BD rekonstruiert und diese in einem Speicher 16 hinterlegt und/oder über die Schnittstelle 17 an das Terminal 20 übergibt, so dass der Bediener sie betrachten kann. Die Bilddaten BD können auch über ein Netzwerk NW an anderen Stellen gespeichert und/oder angezeigt und ausgewertet werden. Sofern die Lokalspulen 6 eine geeignete Umschalteinheit aufweisen, können auch diese an eine HF-Sende-/Empfangseinheit 12 angeschlossen sein, um die Lokalspulen auch zum Senden insbesondere im pTX-Betrieb zu verwenden.

Die Gradientensteuerung 11, die HF-Sende-/Empfangseinheit 12 und die Empfangseinheit 13 für die Lokalspulen 6 werden jeweils koordiniert durch eine Messsteuereinheit 15 angesteuert. Diese sorgt durch entsprechende Befehle dafür, dass ein gewünschter Gradienten-Pulszug GP durch geeignete Gradientensteuersignale SGx, SGy, SGz ausgesendet wird, und steuert parallel die HF-Sende-/Empfangseinheit 12 so an, dass ein Mehrkanal-Pulszug MP ausgesendet wird, d. h. dass auf den einzelnen Sendekanälen K₁, ... K_{N} parallel die passenden Hochfrequenzpulse auf die einzelnen Sendestäbe der Ganzkörperspule 5 gegeben werden. Außerdem muss dafür gesorgt werden, dass zum passenden Zeitpunkt die Magnetresonanzsignale an den Lokalspulen 6 durch die HF-Empfangseinheit 13 bzw. eventuelle Signale an der Ganzkörperspule 5 durch die HF-Sende-/Empfangseinheit 12 ausgelesen und weiterverarbeitet werden. Die Messsteuereinheit 15 gibt die entsprechenden Signale, insbesondere den Mehrkanal-Pulszug MP an die Hochfrequenz-Sende-/Empfangseinheit 12 und den Gradienten-Pulszug GP an die Gradienten-Steuereinheit 11, gemäß einem vorgegebenen Steuerprotokoll P vor. In diesem Steuerprotokoll P sind alle Steuerdaten hinterlegt, die während einer Messung gemäß einer vorgegebenen Pulssequenz PS eingestellt werden müssen.

Üblicherweise sind in einem Speicher 16 eine Vielzahl von Steuerprotokollen P für verschiedene Messungen hinterlegt. Diese könnten über das Terminal 20 vom Bediener ausgewählt und gegebenenfalls variiert werden, um dann ein passendes Steuerprotokoll P für die aktuell gewünschte Messung zur Verfügung zu haben, mit dem die Messsteuereinheit 15 arbeiten kann. Im Übrigen kann der Bediener auch über ein Netzwerk NW Steuerprotokolle P, beispielsweise von einem Hersteller des Magnetresonanzsystems, abrufen und diese dann gegebenenfalls modifizieren und nutzen.

Der grundlegende Ablauf einer solchen Magnetresonanzmessung und die genannten Komponenten zur Ansteuerung sind dem Fachmann aber bekannt, so dass sie hier im Detail nicht weiter besprochen werden. Im Übrigen kann ein solcher Magnetresonanzscanner 2 sowie die zugehörige Steuereinrichtung noch eine Vielzahl weiterer Komponenten aufweisen, die hier ebenfalls nicht im Detail erläutert werden. Es wird an dieser Stelle darauf hingewiesen, dass der Magnetresonanzscanner 2 auch anders aufgebaut sein kann, beispielsweise mit einem seitlich offenen Patientenraum, und dass im Prinzip die Hochfrequenz-Ganzkörperspule nicht als Birdcage-Antenne aufgebaut sein muss.

In Fig. 1 ist außerdem eine erfindungsgemäße Pulssequenz-Ermittlungseinrichtung 22 (auch als "Erstellungseinheit" bezeichnet) schematisch dargestellt, die zur Ermittlung einer Pulssequenz PS dient. Diese Pulssequenz PS enthält u. a. für eine bestimmte Messung einen Pulszug GP, um eine bestimmte Trajektorie im k-Raum zu durchlaufen, sowie einen dazu koordinierten Hochfrequenz-Pulszug, hier einen Mehrkanal-Pulszug MP, zur Ansteuerung der einzelnen Sendekanäle K₁, ..., K_{N}.

Die Pulssequenz PS wird im vorliegenden Fall auf Basis des erfindungsgemäßen Verfahren erstellt. Die Pulssequenz-Ermittlungseinrichtung 22 kann dabei in dem Magnetresonanztomographie-System 1 umfasst sein und Bestandteil des Terminals 20 oder insbesondere auch Bestandteil der Steuereinrichtung 10 sein. Jedoch kann die Pulssequenz-Ermittlungseinrichtung 22 auch extern als eigenständige Baueinheit vorliegen und zur Nutzung mit mehreren unterschiedlichen Magnetresonanzsystemen ausgebildet sein.

Aus dem zuvor Beschriebenen wird deutlich, dass die Erfindung wirkungsvoll Möglichkeiten bereitstellt, um ein Verfahren zur Ansteuerung eines Magnetresonanztomographie-Systems zur Erzeugung von Magnetresonanzbilddaten bezüglich Geschwindigkeit, Flexibilität und Bildqualität zu verbessern.

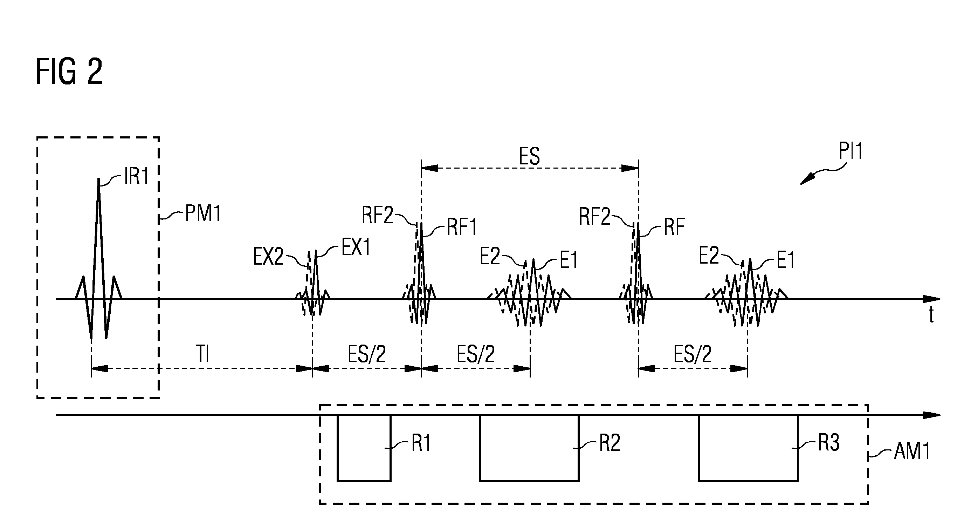

Figur 2 zeigt eine erste Puls-Iteration PI1 als Teil einer beispielhaften Pulssequenz PS, welche jedoch nicht Teil der beanspruchten Erfindung ist. Die Zeitachse t verläuft von links nach rechts. Es werden zwei Teilvolumina aufgenommen.

Angeführt wird die erste Puls-Iteration PI1 von einem ersten Präparationspulsmodul PM1 welches hier lediglich einen Präparationspuls IR1 umfasst. Dieser Präparationspuls präpariert das erste Teilvolumen S1 aber nicht das zweite Teilvolumen S2.

Nach Verstreichen einer Inversionszeit TI erfolgen zwei Anregungspulse EX1, EX2, die typischerweise zeitgleich ausgespielt werden (s. z.B. "Blipped-Controlled Aliasing in Parallel Imaging for Simultaneous Multislice Echo Planar Imaging With Reduced g-Factor Penalty"; Setsompop et al. Magnetic Resonance in Medicine 67:1210-1224 (2012)) und sind hier lediglich zum besseren Verständnis leicht zeitlich versetzt gezeichnet (ebenso wie die Refokussierungs-Pulse RF1, RF2 und die Echos E1, E2). Die Anregungspulse EX1, EX2 werden nach einem halben Echo-Verhältnis ES/2 (engl.: Echo-Spacing) von zwei Refokussierungspulsen RF1, RF2 gefolgt. Die jeweils beiden Pulse wirken auf die beiden aufgenommenen Teilvolumina S1, S2. Zwischen den Anregungspulsen EX1, EX2 und Refokussierungspulsen RF1, RF2 wird ein erster Auslesegradient R1 appliziert. Dieser erste Auslesegradient R1 wird typischerweise auch als "Präphasierungsgradient" bezeichnet. Er präphasiert die Spins so, dass das k-Raum-Zentrum bei den folgenden Auslesen genau auf den Zeitpunkt ES/2 fällt. Nach einem weiteren halben Echo-Verhältnis ES/2 erfolgt ein erstes Echo E1, E2 für jedes Teilvolumen S1, S2 innerhalb eines zweiten Auslesegradienten R2. Ein ganzes Echo-Verhältnis ES nach den Refokussierungspulsen RF1, RF2 wiederholt sich die Abfolge Refokussierungspulse RF1, RF2 und Echo E1, E2 im Rahmen einer weiteren Auslese R3. Die Auslesegradienten stellen das erste Auslesemodul AM1 dar.

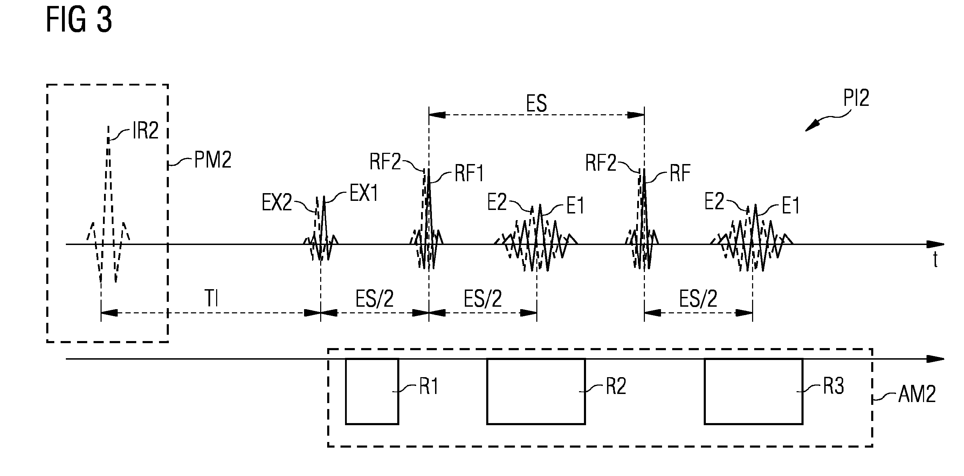

Figur 3 zeigt eine weitere Puls-Iteration PI2 als Teil einer beispielhaften Pulssequenz PS, welche jedoch nicht Teil der beanspruchten Erfindung ist. Die Zeitachse t verläuft wieder von links nach rechts.

Angeführt wird die zweite Puls-Iteration PI2 von einem zweiten Präparationspulsmodul PM2 welches hier ebenfalls lediglich einen Präparationspuls IR2 umfasst, der zur besseren Unterscheidung zum ersten Präparationspuls IR1 gestrichelt dargestellt ist.

Die Auslese mit dem Auslesemodul AM2 erfolgt entsprechend zur Auslese in Figur 2, wobei nun das zweite Teilvolumen S2 durch das zweite Präparationspulsmodul PM2 präpariert worden ist und das erste Teilvolumen S1 nicht.

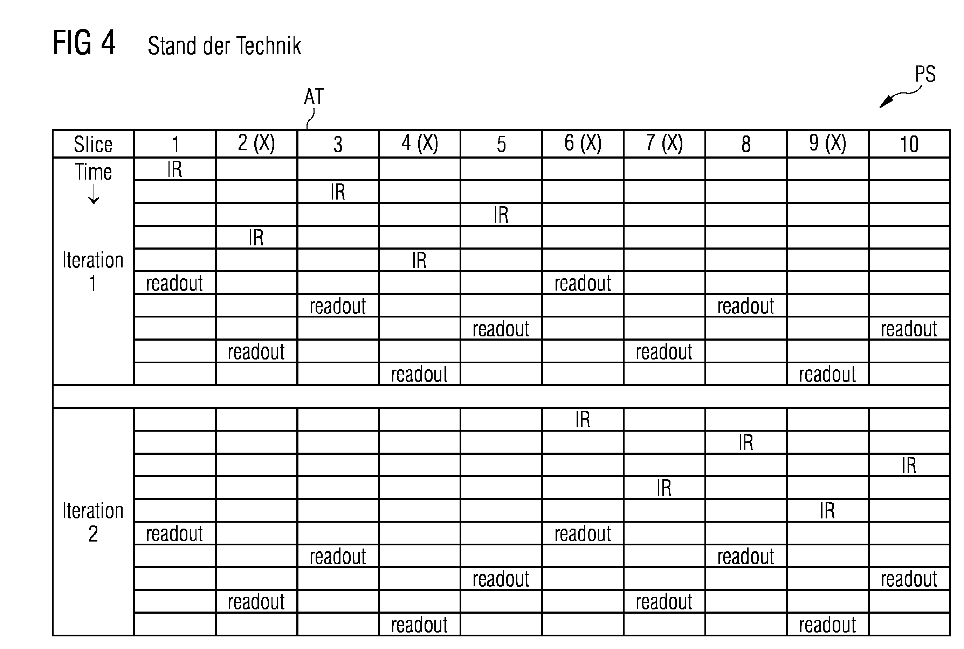

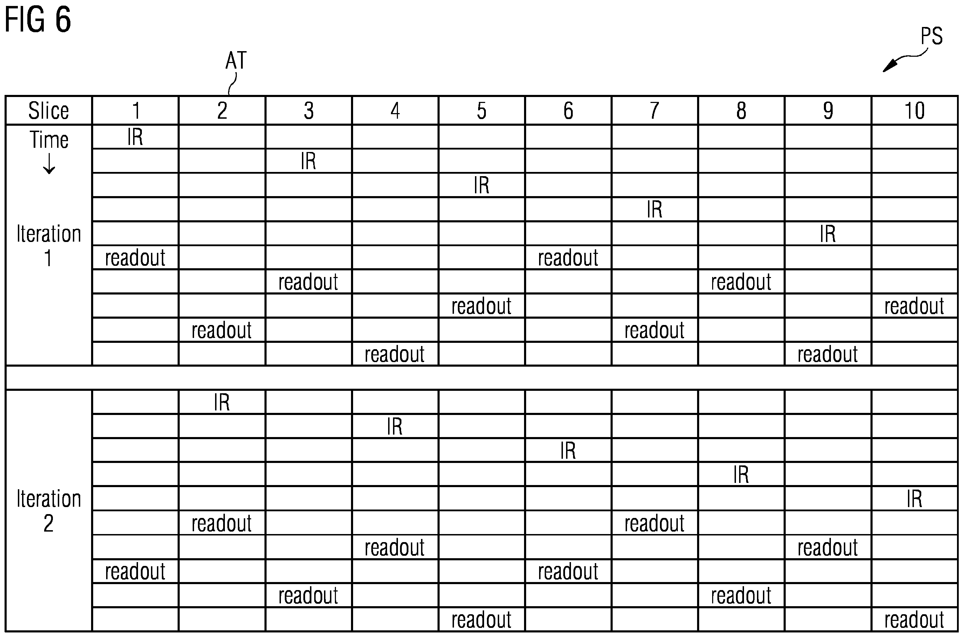

Figur 4 zeigt eine Ablauf-Tabelle AT als Beispiel einer Pulssequenz PS gemäß dem Stand Technik. Die Figuren 5 und 6 bevorzugte Ablauf-Tabellen AT gemäß der Erfindung.

In diesen Ablauf-Tabellen AT sind nur die für die Erfindung wichtigsten Signale eingezeichnet. Im Hinblick auf die Pulssequenz wird auf die Figuren 2 und 3 verwiesen, mit dem Unterschied, dass nun insgesamt 10 Teilvolumina ("Slice") ausgelesen werden. Die Präparationspulse innerhalb einer Puls-Iteration PI1, PI2 sind z.B. so angeordnet, dass sie alle innerhalb der Inversionszeit TI appliziert werden. Die Zeit verläuft von oben nach unten, so dass zunächst Iteration 1 und dann Iteration 2 durchlaufen wird.

In Figur 4 (Stand der Technik) werden die ersten 5 benachbarten Teilvolumina S1, S2, S3, S4, S5 in der ersten Puls-Iteration PI1 präpariert. Dies führt zu Übersprechern in den Teilvolumina S2 und S4, die mit "(X)" gekennzeichnet sind. In der zweiten Puls-Iteration PI2 werden die zweiten 5 benachbarten Teilvolumina S6, S7, S8, S9, S10 präpariert. Dies führt zu Übersprechern in den Teilvolumina S6, S7 und S9, die ebenfalls mit "(X)" gekennzeichnet sind.

In den Figuren 5 und 6 werden die ungeradzahligen 5 Teilvolumina S1, S3, S5, S7, S9 in der ersten Puls-Iteration PI1 präpariert und die geradzahligen 5 Teilvolumina S2, S4, S6, S8, S10 in der zweiten Puls-Iteration PI2 (es wäre auch umgekehrt möglich). Appliziert man diese Pulssequenzen PS, so kann man keine Übersprecher in den Aufnahmen feststellen.

In Figur 5 sind die Zeitabstände zwischen den Präparationspulsen für das erste Teilvolumen S1 und das zweite Teilvolumen S2 bzw. für das dritte Teilvolumen S3 und das vierte Teilvolumen S4 besonders lang gewählt.

In Figur 6 sind die Zeitabstände zwischen den Präparationspulsen für die ungeradzahligen und geradzahligen Präparationspulsen möglichst äquidistant gewählt.

Es wird abschließend noch einmal darauf hingewiesen, dass es sich bei den vorhergehend detailliert beschriebenen Verfahren sowie bei dem dargestellten Magnetresonanztomographie-System 1 lediglich um Ausführungsbeispiele handelt, welche vom Fachmann in verschiedenster Weise modifiziert werden können, ohne den Schutzumfang der Erfindung zu verlassen, welcher durch die Ansprüche gegeben ist. Weiterhin schließt die Verwendung der unbestimmten Artikel "ein" bzw. "eine" nicht aus, dass die betreffenden Merkmale auch mehrfach vorhanden sein können. Ebenso schließen die Begriffe "Einheit" und "Modul" nicht aus, dass die betreffenden Komponenten aus mehreren zusammenwirkenden Teil-Komponenten bestehen, die gegebenenfalls auch räumlich verteilt sein können.

## Patentansprüche

1. Verfahren zur Erstellung einer Pulssequenz (PS) zur Ansteuerung eines Magnetresonanztomographie-Systems (1) zur Erzeugung von Magnetresonanzbilddaten (BD) eines Untersuchungsobjekts (O) für eine Multi-Kontrast-Aufnahme, bei dem zur Erfassung von Magnetresonanzrohdaten (RD) unterschiedliche Transversalmagnetisierungen in einer Mehrzahl von abzubildenden Teilvolumina (S1, S2, S3, S4, S5, S6, S7, S8, S9, S10) gleichzeitig angeregt werden und zur Bildgebung genutzt werden, wobei die Teilvolumina (S1, S2, S3, S4, S5, S6, S7, S8, S9, S10) Schichten sind und mindestens eine der gleichzeitig angeregten Schichten eine andere Präparation erfährt als eine der anderen gleichzeitig angeregten Schichten,
wobei die Pulssequenz (PS) eine Folge von Puls-Iterationen (PI1, PI2) umfasst, die dazu ausgelegt sind, Teilvolumina (S1, S2, S3, S4, S5, S6, S7, S8, S9, S10) zu präparieren, anzuregen und auszulesen, wobei die Puls-Iterationen (PI1, PI2) in der Pulssequenz (PS) in einer Weise angeordnet werden, dass bei einer Applikation der Pulssequenz (PS) zwischen einer Präparation zweier räumlich direkt benachbarter Teilvolumina (S1, S2, S3, S4, S5, S6, S7, S8, S9, S10) eine Auslese erfolgt,
wobei die Pulssequenz (PS) eine erste Puls-Iteration (PI1) und eine darauf folgende zweite Puls-Iteration (PI2) umfasst, **dadurch gekennzeichnet, dass** die erste Puls-Iteration (PI1) ein erstes Präparationspulsmodul (PM1) zur Präparation eines ersten Teilvolumens (S1) und ein erstes Auslesemodul (AM1) nach dem ersten Präparationspulsmodul (PM1) und die zweite Puls-Iteration (PI2) ein zweites Präparationspulsmodul (PM2) zur Präparation eines zweiten Teilvolumens (S2), und ein zweites Auslesemodul (AM2) nach dem zweiten Präparationspulsmodul (PM2) umfasst,
wobei die erste Puls-Iteration (P1) zwischen dem ersten Präparationspulsmodul (PM1) und dem ersten Auslesemodul (AM1) mindestens ein drittes Präparationspulsmodul zum Präparieren eines dritten Teilvolumens (S3) umfasst.

2. Verfahren nach Anspruch 1, wobei die erste Puls-Iteration (PI1) nach dem ersten Auslesemodul (AM1) ein drittes Auslesemodul umfasst.

3. Verfahren nach Anspruch 2, wobei
die zweite Puls-Iteration (PI2) zwischen dem zweiten Präparationspulsmodul (PM2) und dem zweiten Auslesemodul (AM2) mindestens ein viertes Präparationspulsmodul zum Präparieren eines vierten Teilvolumens (S4) umfasst und bevorzugt nach dem zweiten Auslesemodul (AM2) ein viertes Auslesemodul umfasst.

4. Verfahren nach einem der vorangehenden Ansprüche, wobei die Pulssequenz (PS) basierend auf einer automatisch ermittelten Ablauf-Tabelle (AT) erstellt wird, wobei nach einer Eingabe einer Teilvolumenmenge von räumlich direkt benachbarten, parallel angeordneten Teilvolumina (S1, S2, S3, S4, S5, S6, S7, S8, S9, S10), einer Anregungsmenge der gleichzeitig angeregten Teilvolumina der Teilvolumenmenge und einer Messungs-Menge umfassend die durchzuführenden Messungen an den Teilvolumina (S1, S2, S3, S4, S5, S6, S7, S8, S9, S10) die zeitliche Positionierung der Präparationspulsmodule (PM1, PM2) und der Auslesemodule (AM1, AM2) so vorgenommen wird, dass bei einer Applikation der Pulssequenz (PS) eine Präparation direkt benachbarter Teilvolumina (S1, S2, S3, S4, S5, S6, S7, S8, S9, S10) in unterschiedlichen Puls-Iterationen (PI1, PI2) erfolgt.

5. Verfahren nach einem der vorangehenden Ansprüche, wobei
die Pulssequenz (PS) so gebildet wird, dass die zeitlichen Abstände von Gruppen von Präparationspulsmodulen (PM1, PM2), insbesondere aller Präparationspulsmodule (PM1, PM2), zur Präparation direkt benachbarten Teilvolumina (S1 S2, S3, S4) im Wesentlichen gleich ist,
wobei bevorzugt in einer ersten Puls-Iteration (PI1) eine zeitlich aufeinanderfolgende Präparation jedes Teilvolumens (S1, S2) mit ungeradzahliger oder geradzahliger Position erfolgt.

6. Verfahren nach einem der vorangehenden Ansprüche, wobei die Pulssequenz (PS) eine Sequenz der Gruppe EPI (Echo Planar Imaging), insbesondere segmentiertes EPI, GRE (Gradienten-Echo), RESOLVE (In Ausleserichtung segmentierte Echo-Planar-Bildgebungssequenz), SE (Spin Echo), STEAM (Stimulated Echo Acquisition Mode), STIR (Short-Tau Inversion Recovery), TSE (Turbo-Spin-Echo) und FLAIR (Fluid Attenuated Inversion Recovery) umfasst, wobei FLAIR besonders bevorzugt ist.

7. Verfahren nach einem der vorangehenden Ansprüche, wobei die Pulssequenz (PS) zur Aufnahme eines der Kontraste
- Spin-Gitter-Relaxation T1
- Spin-Spin-Relaxation T2
- Protonendichte PD ausgelegt ist, wobei die folgenden Kontrastkombinationen bevorzugt sind:
- Kombination mit Inversionspräparationen, insbesondere
- T1 oder T2 oder PD kombiniert mit T1 FLAIR oder T2 FLAIR oder PD FLAIR
- T1 oder T2 oder PD kombiniert mit T1 STIR oder T2 STIR oder PD STIR
- Kombination mit räumlich selektiver Fettsättigung, insbesondere
- T1 oder T2 oder PD kombiniert mit T1-fs oder T2-fs oder PD-fs
- Kombination mit Diffusion, insbesondere
- EPI T2* kombiniert mit EPI Diff, RESOLVE T2* kombiniert mit RESOLVE Diff
- T1-Präparation (STEAM), insbesondere
- T2 kombiniert mit T1-STEAM.

8. Pulssequenz (PS), insbesondere erstellt nach einem Verfahren nach einem der vorangehenden Ansprüche, zur Ansteuerung eines Magnetresonanztomographie-Systems (1) zur Erzeugung von Magnetresonanzbilddaten (BD) eines Untersuchungsobjekts (O) für eine Multi-Kontrast-Aufnahme, bei dem Magnetresonanzrohdaten (RD) erfasst werden, wobei unterschiedliche Transversalmagnetisierungen in einer Mehrzahl von abzubildenden Teilvolumina (S1, S2, S3, S4, S5, S6, S7, S8, S9, S10) gleichzeitig angeregt werden und zur Bildgebung genutzt werden, wobei die Teilvolumina (S1, S2, S3, S4, S5, S6, S7, S8, S9, S10) Schichten sind und mindestens eine der gleichzeitig angeregten Schichten eine andere Präparation erfährt als eine der anderen gleichzeitig angeregten Schichten, und wobei diese unterschiedlichen Transversalmagnetisierungen mindestens in einem Zeitabschnitt der Messung simultan vorliegen,
wobei die Pulssequenz (PS) eine Folge von Puls-Iterationen (PI1, PI2) umfasst, die dazu ausgelegt sind, Teilvolumina (S1, S2, S3, S4, S5, S6, S7, S8, S9, S10) zu präparieren, anzuregen und auszulesen, wobei die Puls-Iterationen (PI1, PI2) in der Pulssequenz (PS) in einer Weise angeordnet sind, dass bei einer Applikation der Pulssequenz (PS) zwischen einer Präparation zweier räumlich direkt benachbarter Teilvolumina (S1, S2, S3, S4, S5, S6, S7, S8, S9, S10) eine Auslese erfolgt,
wobei die Präparationspulsmodule (PM1, PM2) so angeordnet sind, dass bei einer Applikation der Pulssequenz (PS) eine Präparation direkt benachbarter Teilvolumina (S1, S2, S3, S4, S5, S6, S7, S8, S9, S10) in unterschiedlichen Puls-Iterationen (PI1, PI2) erfolgt,
wobei die Pulssequenz (PS) eine erste Puls-Iteration (PI1) und eine darauf folgende zweite Puls-Iteration (PI2) umfasst,
**dadurch gekennzeichnet, dass** die erste Puls-Iteration (PI1) ein erstes Präparationspulsmodul (PM1) zur Präparation eines ersten Teilvolumens (S1) und ein erstes Auslesemodul (AM1) nach dem ersten Präparationspulsmodul (PM1) und die zweite Puls-Iteration (PI2) ein zweites Präparationspulsmodul (PM2) zur Präparation eines zweiten Teilvolumens (S2), und ein zweites Auslesemodul (AM2) nach dem zweiten Präparationspulsmodul (PM2) umfasst,
wobei die erste Puls-Iteration (P1) zwischen dem ersten Präparationspulsmodul (PM1) und dem ersten Auslesemodul (AM1) mindestens ein drittes Präparationspulsmodul zum Präparieren eines dritten Teilvolumens (S3) umfasst.

9. Vorrichtung umfassend eine Erstellungseinheit (22) ausgelegt zur Erstellung einer Pulssequenz (PS) nach Anspruch 8.

10. Steuerverfahren zur Ansteuerung eines Magnetresonanztomographie-Systems (1) zur Erzeugung von Magnetresonanzbilddaten (BD) eines Untersuchungsobjekts (O), bei dem Magnetresonanzrohdaten (RD) erfasst werden,
wobei unterschiedliche Transversalmagnetisierungen in einer Mehrzahl von abzubildenden Teilvolumina (S1, S2, S3, S4, S5, S6, S7, S8, S9, S10)
angeregt werden und zur Bildgebung genutzt werden, umfassend die Schritte:
- Erstellung einer Pulssequenz (PS) nach einem der Ansprüche 1 bis 7,
- Applikation der Pulssequenz (PS) im Rahmen einer Magnetresonanztomographie-Aufnahme des Magnetresonanztomographie-Systems (1), wobei eine Präparation der Teilvolumina (S1, S2, S3, S4, S5, S6, S7, S8, S9, S10) basierend auf der Pulssequenz (PS) erfolgt.

11. Steuerverfahren nach Anspruch 10, umfassend die Schritte:
- Wählen einer Teilvolumenmenge von räumlich direkt benachbarten, parallel angeordneten Teilvolumina (S1, S2, S3, S4, S5, S6, S7, S8, S9, S10),
- Wählen einer Anregungsmenge der gleichzeitig angeregten Teilvolumina (S1, S2, S3, S4, S5, S6, S7, S8, S9, S10) der Teilvolumenmenge,
- Wählen einer Messungs-Menge umfassend die durchzuführenden Messungen an den Teilvolumina (S1, S2, S3, S4, S5, S6, S7, S8, S9, S10),
- automatische Erstellung einer Pulssequenz (PS) gemäß eines Verfahrens nach einem der Ansprüche 1 bis 7, wobei die Verteilung der Präparationspulsmodule (PM1, PM2) auf die Messungs-Menge so gewählt wird, dass innerhalb einer Messung keine benachbarten Teilvolumina (S1, S2, S3, S4, S5, S6, S7, S8, S9, S10) von einem der Präparationspulsmodule (PM1, PM2) präpariert werden,
- Präparation der Teilvolumina (S1, S2, S3, S4, S5, S6, S7, S8, S9, S10) mittels der Pulssequenz (PS) für eine Messung, wobei bevorzugt jeweils Teilvolumina (S1, S2, S3, S4, S5, S6, S7, S8, S9, S10) gemäß der Anregungsmenge in einer Messung gleichzeitig angeregt und ausgelesen werden und von diesen gleichzeitig angeregt und ausgelesenen Teilvolumina (S1, S2, S3, S4, S5, S6, S7, S8, S9, S10) jeweils mindestens ein Teilvolumen (S1, S2, S3, S4, S5, S6, S7, S8, S9, S10) vorab mit einem Präparationspulsmodul (PM1, PM2) präpariert wurde,
- Wiederholung der Präparation der Teilvolumina (S1, S2, S3, S4, S5, S6, S7, S8, S9, S10) bis alle Messungen aufgenommen wurden.

12. Steuereinrichtung (10) zur Steuerung eines Magnetresonanztomographie-Systems (1), welche zur Durchführung eines Steuerverfahrens nach Anspruch 10 ausgestaltet ist und welche eine Vorrichtung gemäß Anspruch 9 umfasst.

13. Magnetresonanztomographie-System (1) umfassend eine Steuereinrichtung (10) nach Anspruch 12.

14. Computerprogrammprodukt mit einem Computerprogramm, welches direkt in eine Speichereinrichtung einer Steuereinrichtung eines Magnetresonanztomographie-Systems (1) ladbar ist, mit Programmabschnitten, um alle Schritte des Verfahrens nach einem der Ansprüche 1 bis 7 oder des Steuerverfahrens nach Anspruch 10 oder 11 auszuführen, wenn das Computerprogramm in der Steuereinrichtung des Magnetresonanztomographie-Systems (1) ausgeführt wird.

15. Computerlesbares Medium, auf welchem ein Computerprogramm gespeichert ist, welches direkt in eine Speichereinrichtung einer Steuereinrichtung eines Magnetresonanztomographie-Systems (1) ladbar ist, mit Programmabschnitten, um alle Schritte des Verfahrens nach einem der Ansprüche 1 bis 7 oder des Steuerverfahrens nach Anspruch 10 oder 11 auszuführen, wenn das Computerprogramm in der Steuereinrichtung des Magnetresonanztomographie-Systems (1) ausgeführt wird.

## Claims

1. Method for creating a pulse sequence (PS) for controlling a magnetic resonance tomography system (1) for generating magnetic resonance image data (BD) of an examination object (O) for a multi-contrast acquisition, in which, in order to acquire magnetic resonance raw data (RD), different transverse magnetisations are simultaneously excited in a plurality of partial volumes (S1, S2, S3, S4, S5, S6, S7, S8, S9, S10) for imaging and are used for imaging, wherein the partial volumes (S1, S2, S3, S4, S5, S6, S7, S8, S9, S10) are slices and at least one of the simultaneously excited slices experiences a different preparation to one of the other simultaneously excited slices,
wherein the pulse sequence (PS) comprises a sequence of pulse iterations (PI1, PI2) which are configured to prepare, excite and read out partial volumes (S1, S2, S3, S4, S5, S6, S7, S8, S9, S10), wherein the pulse iterations (PI1, PI2) are arranged in the pulse sequence (PS) in such a way that a readout occurs when the pulse sequence (PS) is applied between a preparation of two spatially directly adjacent partial volumes (S1, S2, S3, S4, S5, S6, S7, S8, S9, S10),
wherein the pulse sequence (PS) comprises a first pulse iteration (PI1) and a following second pulse iteration (PI2), **characterised in that** the first pulse iteration (PI1) comprises a first preparation pulse module (PM1) for preparation of a first partial volume (S1), and a first readout module (AM1) after the first preparation pulse module (PM1), and the second pulse iteration (PI2) comprises a second preparation pulse module (PM2) for preparation of a second partial volume (S2), and a second readout module (AM2) after the second preparation pulse module (PM2),
wherein the first pulse iteration (P1) between the first preparation pulse module (PM1) and the first readout module (AM1) comprises at least a third preparation pulse module for preparing a third partial volume (S3).

2. Method according to claim 1, wherein the first pulse iteration (PI1) comprises a third readout module after the first readout module (AM1).

3. Method according to claim 2, wherein
the second pulse iteration (PI2) between the second preparation pulse module (PM2) and the second readout module (AM2) comprises at least a fourth preparation pulse module for preparing a fourth partial volume (S4) and preferably after the second readout module (AM2), comprises a fourth readout module.

4. Method according to one of the preceding claims, wherein the pulse sequence (PS) is created on the basis of an automatically determined sequence table (AT), wherein after inputting a partial volume quantity of spatially directly adjacent, parallel partial volumes (S1, S2, S3, S4, S5, S6, S7, S8, S9, S10), an excitation quantity of the simultaneously excited partial volumes of the partial volume quantity and a scan quantity comprising the scans to be carried out on the partial volumes (S1, S2, S3, S4, S5, S6, S7, S8, S9, S10), the temporal positioning of the preparation pulse modules (PM1, PM2) and the readout modules (AM1, AM2) is performed such that when the pulse sequence (PS) is applied, directly adjacent partial volumes (S1, S2, S3, S4, S5, S6, S7, S8, S9, S10) are prepared in different pulse iterations (PI1, PI2).

5. Method according to one of the preceding claims, wherein
the pulse sequence (PS) is formed such that the time intervals of groups of preparation pulse modules (PM1, PM2), in particular of all preparation pulse modules (PM1, PM2), is essentially the same for the preparation of directly adjacent partial volumes (S1 S2, S3, S4),
wherein each partial volume (S1, S2) with odd-numbered or even-numbered position is successively prepared preferably in a first pulse iteration (PI1).

6. Method according to one of the preceding claims, wherein the pulse sequence (PS) comprises a sequence of the group EPI (Echo Planar Imaging), in particular segmented EPI, GRE (Gradient Echo), RESOLVE (echo planar imaging sequence segmented in the readout direction), SE (Spin Echo), STEAM (Stimulated Echo Acquisition Mode), STIR (Short-Tau Inversion Recovery), TSE (Turbo-Spin-Echo) and FLAIR (Fluid Attenuated Inversion Recovery), wherein FLAIR is particularly preferred.

7. Method according to one of the preceding claims, wherein the pulse sequence (PS) is configured for acquisition of one of the following contrasts
- spin-grid relaxation T1
- spin-spin relaxation T2
- proton density PD, wherein the following contrast combinations are preferred:
- combination with inversion preparations, in particular
- T1 or T2 or PD combined with T1 FLAIR or T2 FLAIR or PD FLAIR
- T1 or T2 or PD combined with T1 STIR or T2 STIR or PD STIR
- combination with spatially selective fat saturation, in particular
- T1 or T2 or PD combined with T1-fs or T2-fs or PD-fs
- combination with diffusion, in particular
- EPI T2* combined with EPI Diff, RESOLVE T2* combined with RESOLVE Diff
- T1-preparation (STEAM), in particular
- T2 combined with T1-STEAM.

8. Pulse sequence (PS), in particular created according to a method according to one of the preceding claims, for controlling a magnetic resonance tomography system (1) for generating magnetic resonance image data (BD) of an examination object (O) for a multi-contrast acquisition, in which magnetic resonance raw data (RD) is acquired, wherein different transverse magnetisations are simultaneously excited in a plurality of partial volumes (S1, S2, S3, S4, S5, S6, S7, S8, S9, S10) for imaging and are used for imaging, wherein the partial volumes (S1, S2, S3, S4, S5, S6, S7, S8, S9, S10) are slices and at least one of the simultaneously excited slices experiences a different preparation to one of the other simultaneously excited slices, and wherein these different transverse magnetisations exist simultaneously at least in one period of the scan,
wherein the pulse sequence (PS) comprises a sequence of pulse iterations (PI1, PI2) which are configured to prepare, excite and read out partial volumes (S1, S2, S3, S4, S5, S6, S7, S8, S9, S10), wherein the pulse iterations (PI1, PI2) are arranged in the pulse sequence (PS) in such a way that a readout occurs when the pulse sequence (PS) is applied between a preparation of two spatially directly adjacent partial volumes (S1, S2, S3, S4, S5, S6, S7, S8, S9, S10),
wherein the preparation pulse modules (PM1, PM2) are arranged such that when the pulse sequence (PS) is applied, directly adjacent partial volumes (S1, S2, S3, S4, S5, S6, S7, S8, S9, S10) are prepared in different pulse iterations (PI1, PI2), wherein the pulse sequence (PS) comprises a first pulse iteration (PI1) and a following second pulse iteration (PI2), **characterised in that** the first pulse iteration (PI1) comprises a first preparation pulse module (PM1) for preparation of a first partial volume (S1), and a first readout module (AM1) after the first preparation pulse module (PM1), and the second pulse iteration (PI2) comprises a second preparation pulse module (PM2) for preparation of a second partial volume (S2), and a second readout module (AM2) after the second preparation pulse module (PM2),
wherein the first pulse iteration (P1) between the first preparation pulse module (PM1) and the first readout module (AM1) comprises at least a third preparation pulse module for preparing a third partial volume (S3).

9. Device comprising a creation unit (22) configured for creating a pulse sequence (PS) according to claim 8.

10. Control method for controlling a magnetic resonance tomography system (1) for generating magnetic resonance image data (BD) of an examination object (O), wherein magnetic resonance raw data (RD) is acquired,
wherein different transverse magnetisations are excited in a plurality of partial volumes (S1, S2, S3, S4, S5, S6, S7, S8, S9, S10) and are used for imaging, comprising the following steps:
- creating a pulse sequence (PS) according to one of claims 1 to 7,
- application of the pulse sequence (PS) during the course of a magnetic resonance tomography acquisition of the magnetic resonance tomography system (1), wherein the partial volumes (S1, S2, S3, S4, S5, S6, S7, S8, S9, S10) are prepared on the basis of the pulse sequence (PS).

11. Control method according to claim 10, comprising the following steps:
- selecting a partial volume quantity of spatially directly adjacent, parallel partial volumes (S1, S2, S3, S4, S5, S6, S7, S8, S9, S10),
- selecting an excitation quantity of the simultaneously excited partial volumes (S1, S2, S3, S4, S5, S6, S7, S8, S9, S10) of the partial volume quantity,
- selecting a scan quantity comprising the scans to be carried out on the partial volumes (S1, S2, S3, S4, S5, S6, S7, S8, S9, S10),
- automatic creation of a pulse sequence (PS) according to a method according to one of claims 1 to 7, wherein the distribution of the preparation pulse modules (PM1, PM2) among the scan quantity is selected such that within a scan, no adjacent partial volumes (S1, S2, S3, S4, S5, S6, S7, S8, S9, S10) are prepared by one of the preparation pulse modules (PM1, PM2),
- preparation of the partial volumes (S1, S2, S3, S4, S5, S6, S7, S8, S9, S10) by means of the pulse sequence (PS) for a scan, wherein preferably partial volumes (S1, S2, S3, S4, S5, S6, S7, S8, S9, S10) are each simultaneously excited and read out in one scan according to the excitation quantity and of these simultaneously excited and read out partial volumes (S1, S2, S3, S4, S5, S6, S7, S8, S9, S10), at least one partial volume (S1, S2, S3, S4, S5, S6, S7, S8, S9, S10) respectively was prepared in advance with a preparation pulse module (PM1, PM2),
- repetition of the preparation of the partial volumes (S1, S2, S3, S4, S5, S6, S7, S8, S9, S10) until all measurements have been acquired.

12. Control device (10) for controlling a magnetic resonance tomography system (1), which is configured for carrying out a control method according to claim 10 and which comprises a device according to claim 9.

13. Magnetic resonance tomography system (1) comprising a control device (10) according to claim 12.

14. Computer program product having a computer program which can be loaded directly into a storage device of a control device of a magnetic resonance tomography system (1), having program segments in order to carry out all steps of the method according to one of claims 1 to 7 or the control method according to claim 10 or 11 when the computer program is executed in the control device of the magnetic resonance tomography system (1).

15. Computer-readable medium on which a computer program is stored, which can be loaded directly into a storage device of a control device of a magnetic resonance tomography system (1), with program segments in order to carry out all steps of the method according to one of claims 1 to 7 or the control method according to claim 10 or 11 when the computer program is executed in the control device of the magnetic resonance tomography system (1).

## Revendications

1. Procédé d'établissement d'une séquence (PS) d'impulsions pour la commande d'un système (1) de tomodensitométrie par résonnance magnétique pour la production de données (BD) d'image de résonnance magnétique d'un objet (O) à examiner pour un enregistrement à plusieurs contrastes, dans lequel, pour la saisie de données (RD) brutes de résonnance magnétique, on excite en même temps des aimantations transversales différentes dans une pluralité de volumes (S1, S2, S3, S4, S5, S6, S7, S8, S9, S10) partiels à représenter et on les utilise pour la formation d'images, dans lequel les volumes (S1, S2, S3, S4, S5, S6, S7, S8, S9, S10) partiels sont des couches et au moins l'une des couches excitées en même temps subit une préparation autre que l'une des autres couches excitées en même temps,
dans lequel la séquence (PS) d'impulsions comprend une succession d'itérations (PI1, PI2) d'impulsions, qui sont conçues pour préparer, exciter et lire des volumes (S1, S2, S3, S4, S5, S6, S7, S8, S9, S10) partiels, dans lequel on dispose les itérations (PI1, PI2) d'impulsions de la séquence (PS) d'impulsions de façon à ce qu'il se produise, lors d'une application de la séquence (PS) d'impulsions entre une préparation de deux volumes (S1, S2, S3, S4, S5, S6, S7, S8, S9, S10) partiels directement voisins dans l'espace, une lecture,
dans lequel la séquence (PS) d'impulsions comprend une première itération (PI1) d'impulsions et une deuxième itération (PI2) d'impulsions, qui vient ensuite,
**caractérisé en ce que** la première itération (PI1) d'impulsions comprend un premier module (PM1) d'impulsions de préparation pour la préparation d'un premier volume (S1) partiel et un premier module (AM1) de lecture, après le premier module (PM1) d'impulsions de préparation et la deuxième itération (PI2) d'impulsions, un deuxième module (PM2) d'impulsions de préparation pour la préparation d'un deuxième volume (S2) partiel et un deuxième module (AM2) de lecture, après le deuxième module (PM2) d'impulsions de préparation,
dans lequel la première itération (P1) d'impulsions comprend, entre le premier module (PM1) d'impulsions de préparation et le premier module (AM1) de lecture, au moins un troisième module d'impulsions de préparation pour la préparation d'un troisième volume (S3) partiel.

2. Procédé suivant la revendication 1, dans lequel la première itération (PI1) d'impulsions comprend un troisième module de lecture après le premier module (AM1) de lecture.

3. Procédé suivant la revendication 2, dans lequel la deuxième itération (PI2) d'impulsions comprend, entre le deuxième module (PM2) d'impulsions de préparation et le deuxième module (AM2) de lecture, au moins un quatrième module d'impulsions de préparation pour la préparation d'un quatrième volume (S4) partiel et, de préférence, après le deuxième module (AM2) de lecture, un quatrième module de lecture.

4. Procédé suivant l'une des revendications précédentes, dans lequel
on établit la séquence (PS) d'impulsions sur la base d'une table (AT) de déroulement recherchée automatiquement, dans lequel, après l'entrée d'un ensemble de volumes partiels de volumes (S1, S2, S3, S4, S5, S6, S7, S8, S9, S10) partiels disposés en parallèle en étant directement voisins dans l'espace, d'un ensemble d'excitation des volumes partiels excités en même temps de l'ensemble des volumes partiels et d'un ensemble de mesure comprenant les mesures effectuées sur les volumes (S1, S2, S3, S4, S5, S6, S7, S8, S9, S10) partiels, on effectue la mise en position dans le temps des modules (PM1, PM2) d'impulsions de préparation et des modules (AM1, AM2) de lecture, en ce que, lors de l'application de la séquence (PS) d'impulsions, il se produit une préparation de volumes (S1, S2, S3, S4, S5, S6, S7, S8, S9, S10) partiels voisins directement dans des itérations (PI1, PI2) d'impulsions différentes.

5. Procédé suivant l'une des revendications précédentes, dans lequel
on forme la séquence (PS) d'impulsions de manière à ce que les distances dans le temps, entre des groupes de modules (PM1, PM2) d'impulsions de préparation, en particulier de tous les modules (PM1, PM2) d'impulsions de préparation pour la préparation de volumes (S1 S2, S3, S4) partiels voisins directement, soient sensiblement égales,
dans lequel, de préférence, dans une première itération (PI1) d'impulsions, il se produit une préparation, successivement dans le temps, de chaque volume (S1, S2) partiel ayant une position en nombre impair ou en nombre pair.

6. Procédé suivant l'une des revendications précédentes, dans lequel
la séquence (PS) d'impulsions comprend une séquence du groupe EPI (Echo Planar Imaging), en particulier EPI segmenté, GRE (écho de gradient), RESOLVE (séquence d'imagerie plane d'écho segmentée dans la direction de lecture), SE (écho de spin), STEAM (Stimulated Echo Acquisition Mode), STIR (Short-Tau Inversion Recovery), TSE (Turbo Spin Echo), FLAIR (Fluide Attenuated Inversion Recovery), dans lequel on préfère, en particulier, FLAIR.

7. Procédé suivant l'une des revendications précédentes, dans lequel
la séquence (PS) d'impulsions est conçue pour l'enregistrement de l'un des contrastes
- relaxation spin-réseau T1
- relaxation spin-spin T2
- densité protonique PD
dans lequel on préfère les combinaisons de contrastes suivantes :
- combinaison avec des préparations d'inversion, en particulier
- T1 ou T2 ou PD combiné à FLAIR T1 ou à FLAIR T2 ou à FLAIR PD
- T1 ou T2 combiné à STIR T1 ou à STIR T2 ou à STIR PD
- combinaison d'une saturation de graisse sélective dans l'espace, en particulier
- T1 ou T2 ou PD combiné à fs T1 ou à fs T2 ou à fs PD
- combinaison à une diffusion, en particulier
- EPI T2* combiné à EPI Diff, RESOLVE T2* combiné à RESOLVE Diff
- Préparation T1 (STEAM), en particulier
- T2 combiné à T1 STEAM.

8. Séquence (PS) d'impulsions établie, en particulier par un procédé suivant l'une des revendications précédentes, de commande d'un système (1) de tomodensitométrie par résonnance magnétique pour la production de données (BD) d'image de résonnance de résonnance magnétique d'un objet (O) à examiner pour un enregistrement à plusieurs contrastes, dans laquelle on saisit des données (RD) brutes de résonnance magnétique, dans lequel on excite en même temps des aimantations transversales différentes dans une pluralités de volumes (S1, S2, S3, S4, S5, S6, S7, S8, S9, S10) partiels à représenter et on les utilise pour la formation d'images, dans lequel les volumes (S1, S2, S3, S4, S5, S6, S7, S8, S9, S10) partiels sont des couches et au moins l'une des couches excitées en même temps subit une préparation autre que l'une des autres couches excitées en même temps, et dans laquelle ces aimantations transversales différentes ont lieu simultanément au moins dans un laps de temps de la mesure,
dans laquelle la séquence (PS) d'impulsions comprend une succession d'itérations (PI1, PI2) d'impulsions, qui sont conçues pour préparer, exciter et lire des volumes (S1, S2, S3, S4, S5, S6, S7, S8, S9, S10) partiels, dans lequel les itérations (PI1, PI2) d'impulsions de la séquence (PS) d'impulsions sont disposées de manière à ce que, lors d'une application de la séquence (PS) d'impulsions, il s'effectue, entre deux volumes (S1, S2, S3, S4, S5, S6, S7, S8, S9, S10) partiels voisins directement dans l'espace, une lecture,
dans laquelle les modules (PM1, PM2) de préparation sont disposés de manière à ce que, lors d'une application de la séquence (PS) d'impulsions, il s'effectue une préparation de volumes (S1, S2, S3, S4, S5, S6, S7, S8, S9, S10) partiels voisins directement dans des itérations (PI1, PI2) d'impulsions différentes,
dans laquelle la séquence (PS) d'impulsions comprend une première itération (PI1) d'impulsions et une deuxième itération (PI2) d'impulsions venant ensuite,
**caractérisée en ce que** la première itération (PI1) d'impulsions comprend un premier module (PM1) d'impulsions de préparation pour la préparation d'un premier volume (S1) partiel et un premier module (AM1) de lecture après le premier module (PM1) d'impulsions de préparation et la deuxième itération (PI2) d'impulsions, un deuxième module (PM2) d'impulsions de préparation pour la préparation d'un deuxième volume (S2) partiel et un deuxième module (AM2) de lecture après le deuxième module (PM2) d'impulsions de préparation,
dans lequel la première itération (P1) d'impulsions comprend, entre le premier module (PM1) d'impulsions de préparation et le premier module (AM1) de lecture, au moins un troisième module d'impulsions de préparation pour la préparation d'un troisième volume (S3) partiel.

9. Installation comprenant une unité (22) d'établissement conçue pour l'établissement d'une séquence (PS) d'impulsions suivant la revendication 8.

10. Procédé de commande pour la commande d'un système (1) de tomodensitométrie par résonnance magnétique pour la production de données (BD) d'image de résonnance magnétique d'un objet (O) à examiner, dans lequel on saisit des données (RD) de résonnance magnétique,
dans lequel on excite et on utilise pour la formation d'images des aimantations transversales différentes dans une pluralité de volumes (S1, S2, S3, S4, S5, S6, S7, S8, S9, S10) partiels à reproduire, comprenant les stades :
- établissement d'une séquence (PS) d'impulsions suivant l'une des revendications 1 à 7,
- application de la séquence (PS) d'impulsions dans le cadre d'un enregistrement de tomodensitométrie par résonnance magnétique du système (1) de tomodensitométrie par résonnance magnétique, une préparation des volumes (S1, S2, S3, S4, S5, S6, S7, S8, S9, S10) partiels s'effectuant sur la base de la séquence (PS) d'impulsions.

11. Procédé de commande suivant la revendication 10, comprenant les stades
- sélection d'un ensemble de volumes partiels de volumes (S1, S2, S3, S4, S5, S6, S7, S8, S9, S10) partiels disposés parallèlement voisins directement dans l'espace,
- sélection d'un ensemble d'excitation des volumes (S1, S2, S3, S4, S5, S6, S7, S8, S9, S10) partiels excités en même temps de l'ensemble de volumes partiels,
- sélection d'un ensemble de mesure comprenant les mesures à effectuer sur les volumes (S1, S2, S3, S4, S5, S6, S7, S8, S9, S10) partiels,
- établissement automatique d'une séquence (PS) d'impulsions par un procédé suivant l'une des revendications 1 à 7, dans lequel on choisit la répartition des modules (PM1, PM2) d'impulsions de préparation sur l'ensemble de mesures, de manière à ne pas préparer, dans une mesure, des volumes (S1, S2, S3, S4, S5, S6, S7, S8, S9, S10) partiels voisins par l'un des modules (PM1, PM2) de préparation,
- préparation des volumes (S1, S2, S3, S4, S5, S6, S7, S8, S9, S10) partiels au moyen de la séquence (PS) d'impulsions pour une mesure, dans lequel, de préférence on excite et on lit en même temps respectivement des volumes (S1, S2, S3, S4, S5, S6, S7, S8, S9, S10) partiels respectifs suivant l'ensemble d'excitation dans une mesure et de ces volumes (S1, S2, S3, S4, S5, S6, S7, S8, S9, S10) partiels excités et lus en même temps, on a préparé respectivement au moins un volume (S1, S2, S3, S4, S5, S6, S7, S8, S9, S10) partiel auparavant par un module (PM1, PM2) d'impulsions,
- répétition de la préparation du volume (S1, S2, S3, S4, S5, S6, S7, S8, S9, S10) partiels jusqu'à ce que toutes les mesures ont été enregistrées.

12. Dispositif (10) de commande pour la commande d'un système (1) de tomodensitométrie par résonnance magnétique, qui est conformé pour effectuer un procédé de commande suivant la revendication 10, et qui comprend une installation suivant la revendication 9.

13. Système (1) de tomodensitométrie par résonnance magnétique comprenant un dispositif (10) de commande suivant la revendication 12.

14. Produit de programme d'ordinateur ayant un programme d'ordinateur, qui peut être chargé directement dans un dispositif de mémoire d'un dispositif de commande d'un système (1) de tomodensitométrie par résonnance magnétique comprenant des parties de programme pour exécuter tous les stades du procédé suivant l'une des revendications 1 à 7 ou du procédé de commande suivant la revendication 10 ou 11, lorsque le programme d'ordinateur est exécuté dans le dispositif de commande du système (1) de tomodensitométrie par résonnance magnétique.

15. Support, déchiffrable par ordinateur, sur lequel est mis en mémoire un programme d'ordinateur, qui peut être chargé directement dans un dispositif de mémoire d'un dispositif de commande d'un système (1) de tomodensitométrie par résonnance magnétique comprenant des parties de programme pour exécuter tous les stades du procédé suivant l'une des revendications 1 à 7 ou du procédé de commande suivant la revendication 10 ou 11, lorsque le programme d'ordinateur est exécuté dans le dispositif de commande du système (1) de tomodensitométrie par résonnance magnétique.
